# EUROPÄISCHE PATENTSCHRIFT

(11) **EP 1 672 094 B1**
(45) Veröffentlichungstag und Bekanntmachung des Hinweises auf die Patenterteilung: **14.11.2007**
(21) Anmeldenummer: 05026256.7
(22) Anmeldetag: 01.12.2005
(51) Int. Cl.: C23C 16/458

(54) **Poröser Suszeptor, Verfahren damit zur Beschichtung einer Halbleiterscheibe und Halbleiterscheibe**
Porous susceptor, method using it to obtain a coated wafer and wafer
Suscepteur poreux, méthode l'utilisant pour l'obtention d'un dépot sur tranche et tranche semiconductrice

(30) Priorität: 16.12.2004 DE 102004060625
(43) Veröffentlichungstag der Anmeldung: 21.06.2006
(73) Patentinhaber: Siltronic AG, 81737 München (DE)
(72) Erfinder: Schauer, Reinhard, 83410 Laufen (DE); Werner, Norbert, 83373 Tengling (DE)
(74) Vertreter: Staudacher, Wolfgang

(56) Entgegenhaltungen:
- US-A- 3 549 847
- US-A1- 2001 037 761
- US-A1- 2004 266 181
- PATENT ABSTRACTS OF JAPAN Bd. 010, Nr. 121 (E-401), 7. Mai 1986 (1986-05-07) -& JP 60 254610 A (FUJITSU KK), 16. Dezember 1985 (1985-12-16)

## Beschreibung

Gegenstand der Erfindung ist eine Halbleiterscheibe mit einer Rückseite und einer durch chemische Gasphasenabscheidung (CVD) beschichteten Vorderseite und einer polierten oder geätzten Rückseite, sowie ein Verfahren zur Herstellung der Halbleiterscheibe. Gegenstand der Erfindung ist auch ein Suszeptor zum Ablegen einer Halbleiterscheibe beim Abscheiden einer Schicht auf einer Vorderseite der Halbleiterscheibe durch chemische Gasphasenabscheidung (CVD).

Bei der chemischen Gasphasenabscheidung (chemical vapor deposition, CVD), insbesondere beim Abscheiden einer epitaktischen Schicht auf einer beidseitig polierten Substratscheibe aus Silicium, ist man unter anderem mit zwei Phänomenen konfrontiert, die unter den Begriffen "autodoping" und "halo" bekannt sind. Beim "autodoping" gelangen Dotierstoffe von der Rückseite der Halbleiterscheibe über die Gasphase in das Abscheidegas, das über die Vorderseite der Halbleiterscheibe geleitet wird. Sie werden dann überwiegend im Randbereich der Vorderseite der Halbleiterscheibe in die epitaktische Schicht eingebaut und rufen dadurch eine mehr oder weniger stark ausgeprägte unerwünschte radiale Schwankung des spezifischen Widerstands der epitaktischen Schicht hervor.

Mit "halo" wird ein Streulichteffekt bezeichnet, der durch lichtstreuende Strukturen auf der Rückseite der Halbleiterscheibe hervorgerufen wird und sich beim Anstrahlen der Rückseite der Halbleiterscheibe mit einem gebündelten Lichtstrahl bemerkbar macht. Die Strukturen markieren Übergänge auf der Oberfläche der Rückseite der Halbleiterscheibe, an denen Bereiche mit nativer Oxidschicht an Bereiche grenzen, wo eine solche Oxidschicht nicht vorhanden ist. Die ebenfalls unerwünschten Übergänge treten auf, wenn das Entfernen der nativen Oxidschicht während einer als "prebake" bezeichneten Vorheizphase vor der eigentlichen Abscheidephase unvollständig war. Eine Möglichkeit, den "halo" Effekt zu quantifizieren, stellt eine Streulicht-Messung des Haze dar, zum Beispiel mit einem Tencor SP1 Gerät im sogenannten DNN (DarkField Narrow Normal) oder DWN Kanal (DarkField Wide Normal).

Um Probleme mit "autodoping" zu vermeiden, wird in der US-6,129,047 vorgeschlagen, Schlitze im Boden der die Halbleiterscheibe aufnehmenden Vertiefung ("pocket") des Suszeptors vorzusehen, wobei die Schlitze am Außenrand des Bodens angeordnet sind. Von der Rückseite der Halbleiterscheibe ausdiffundierende Dotierstoffe können durch Spülgas, das durch Schlitze im Suszeptor auf die Scheibenrückseite geleitet wird, aus dem Reaktor entfernt werden, ohne vorher zur Vorderseite der Halbleiterscheibe zu gelangen. Gemäß der US-2001/0037761 A1 sind für den gleichen Zweck kleine Bohrungen im gesamten Boden des Suszeptors vorhanden. Der Abtransport des von der Rückseite der Halbleiterscheibe ausdiffundierenden Dotierstoffs erfolgt auch hier durch das Vorbeileiten eines Spülgases. Die Maßnahmen sind auch wirksam gegen eine "halo"-Bildung, weil sie das Entfernen der nativen Oxidschicht erleichtern, denn gasförmige Reaktionsprodukte, die beim Auflösen des nativen Oxids entstehen, werden ebenfalls durch die Löcher im Boden und das vorbeiströmende Spülgas abtransportiert.

Allerdings ist die Verwendung des beschriebenen Suszeptors nicht völlig unproblematisch, da die Löcher das Temperaturfeld auf der Rückseite und der Vorderseite der Halbleiterscheibe beeinflussen. Überschreitet der Durchmesser der Löcher im Boden des Suszeptors eine bestimmte Größe, wirkt sich dies negativ auf die Nanotopographie der Vorderseite der Halbleiterscheibe aus. Mit dem Begriff Nanotopographie werden Höhenschwankungen im Nanometerbereich beschrieben, die über einen lateralen Bereich von 0,5 bis 10 mm gemessen werden. Die von den Löchern hervorgerufenen Temperaturschwankungen führen beim Abscheiden der epitaktischen Schicht auf der Vorderseite der Halbleiterscheibe zu lokal unterschiedlichen Abscheideraten und schließlich zu den erwähnten Höhenschwankungen. In der US-2001/0037761 A1 wird zur Vermeidung dieses Problems vorgeschlagen, den Durchmesser der Löcher zu beschränken und das Temperaturfeld durch eine Anpassung der Leistung der Lampenheizung zu vergleichmäßigen.

Diese Maßnahmen sind jedoch nur im Hinblick auf die Vorderseite der Halbleiterscheibe wirksam. Wie die Erfinder der vorliegenden Erfindung feststellten, werden die Nanotopographie-Werte der Rückseite der Halbleiterscheibe sogar schlechter, je kleiner der Durchmesser dieser Löcher im Suszeptor gewählt wird. Das Temperaturfeld auf der Rückseite der Halbleiterscheibe bleibt wegen der Präsenz der Löcher derart ungleichmäßig, dass es zu lokalen Ätzungen, hervorgerufen durch Spülgas, wie beispielsweise Wasserstoff, und zu lokalen Abscheidungen kommt, hervorgerufen durch zur Rückseite der Halbleiterscheibe gelangendes Abscheidegas. Beides beeinträchtigt die Nanotopographie der Rückseite, was nicht toleriert werden kann, denn auch Unebenheiten auf der Rückseite der Halbleiterscheibe können Fokussierungsprobleme des Steppers während der Herstellung elektronischer Bauelemente auf der Vorderseite der Halbleiterscheibe hervorrufen.

Es ist daher die Aufgabe der vorliegenden Erfindung, aufzuzeigen, wie "autodoping", "halo" und eine nachteilige Nanotopographie der Vorderseite und der Rückseite ausreichend vermieden werden kann.

Die US2004/0266181 A1 beschreibt einen Gegenstand, zu dem die vorliegende Erfindung eine Auswahlerfindung ist.

Gegenstand der Erfindung ist eine Halbleiterscheibe mit einer durch chemische Gasphasenabscheidung (CVD) beschichteten Vorderseite und einer polierten oder geätzten Rückseite, die dadurch gekennzeichnet ist, dass die Nanotopographie der Rückseite, ausgedrückt als Höhenschwankung PV (= peak to valley), kleiner als 5 nm ist und gleichzeitig der "halo" der Rückseite, ausgedrückt als Haze, kleiner als 5 ppm ist.

Bei der Halbleiterscheibe handelt es sich vorzugsweise um eine Substratscheibe aus Silicium mit einer epitaktisch abgeschiedenen Schicht auf der Vorderseite. Die Rückseite der beschichteten Halbleiterscheibe ist poliert oder geätzt. Die Substratscheibe ist vorzugsweise p- oder n-dotiert, besonders bevorzugt p-dotiert mit Bor als Dotierstoff, wobei der Dotierungsgrad p⁻, p, p⁺ und p⁺⁺ sein kann. Besonders bevorzugt ist ein Dotierungsgrad p⁺, was einer Leitfähigkeit von etwa 0,005 bis etwa 0,03 Ohm*cm entspricht. Die epitaktische Schicht ist vorzugsweise ebenfalls p-dotiert, besonders bevorzugt mit Bor als Dotierstoff und besitzt vorzugsweise einen Dotierungsgrad p, was einem spezifischen Widerstand von etwa 1 bis etwa 20 Ohm*cm entspricht. Die Dicke der epitaktischen Schicht beträgt vorzugsweise 0,1 µm bis 100 µm und ist in erster Linie abhängig vom vorgesehenen Verwendungszweck. Die Nanotopographie der Vorderseite der beschichteten Halbleiterscheibe beträgt, bezogen auf quadratische Messflächen ("sites") mit einer üblichen Fläche von 0,5 mm * 0,5 mm, 2 mm * 2 mm oder 10 mm * 10 mm, vorzugsweise weniger als 10 nm, besonders bevorzugt weniger als 5 nm. Die Nanotopographie der Rückseite der Halbleiterscheibe ist kleiner als 5 nm, vorzugsweise bezogen auf ein Messfenster mit einer Fläche von 10 mm * 10 mm.

Gegenstand der Erfindung ist auch ein Verfahren zur Herstellung einer Halbleiterscheibe mit einer, auf einer Vorderseite durch chemische Gasphasenabscheidung (CVD) abgeschiedenen Schicht und einer polierten oder geätzten Rückseite, wobei die Halbleiterscheibe zum Abscheiden der Schicht auf einem Suszeptor gemäß Anspruch 1 abgelegt wird, so dass die Rückseite der Halbleiterscheibe einem Boden des Suszeptors zugewandt ist, das dadurch gekennzeichnet ist, dass gasförmige Stoffe aus einem Bereich über der Rückseite der Halbleiterscheibe durch diffusiven Gastransport durch den Suszeptor hindurch in einen Bereich über der Rückseite des Suszeptors gelangen.

Das Verfahren unterscheidet sich von bekannten Verfahren insbesondere durch die Verwendung eines Suszeptors mit poröser Struktur mit kleinem Porendurchmesser und großer innerer Oberfläche der Poren. Dadurch erfolgt der Gastransport diffusiv und nicht in Form eines gerichteten Gasflusses, wie es bei der Verwendung von gelochten Suszeptoren der Fall ist. Membranen aus Graphitfilz werden beispielsweise, allerdings in völlig anderem Zusammenhang, auch beim Bau von Brennstoffzellen verwendet und dienen hier als Diffusionslagen (siehe z.B. A. Heinzel & F. Mahlendorf, Vortrag auf dem 2. Forum Industrielle Gemeinschaftsforschung in Nordrhein-Westfalen, Gelsenkirchen, 12. Februar 2003). Der poröse Suszeptor verhindert die Ausbildung von Strömungsinhomogenitäten in der Nähe der Scheibenrückseite und minimiert die oben beschriebenen Nanotopographie-Effekte. Außerdem wird die Temperaturverteilung auf der Scheibenrück- und Vorderseite homogenisiert. Die Ursache dafür ist die Tatsache, daß der hier beschriebene poröse Suszeptor, im Gegensatz zu gelochten Suszeptoren, eine sehr hohe Dichte unregelmäßig angeordneter, sehr kleiner, gegeneinander räumlich versetzter Poren aufweist, so daß thermische Strahlung nicht mehr ungehindert durch die Poren im Suszeptor hindurch gelangen und keine hierdurch lokal unterschiedliche Erhitzung oder Erwärmung der Scheibenrückseite mehr hervorrufen kann. Die Wirkung des Suszeptors macht sich bereits während der Vorheizphase bemerkbar, wenn die Substratscheibe vorerhitzt wird und einem Spülgas, bestehend aus einem Inertgas (Edelgas oder Stickstoff) und/oder einem reduzierenden Gas (Wasserstoff) ausgesetzt wird, um die native Oxidschicht zu entfernen. Die sich beim Auflösen der Oxidschicht bildenden gasförmigen Reaktionsprodukte entweichen, ebenso wie aus der Substratscheibe diffundierender Dotierstoff, durch die Poren des Suszeptors zur Rückseite des Suszeptors, wo sie vom Strom des Spülgases aufgenommen und aus dem Reaktor entfernt werden. Nach dem Entfernen der Oxidschicht kann dem Spülgas Chlorwasserstoff hinzugefügt werden, vorzugsweise um vor dem Abscheiden der epitaktischen Schicht die Oberfläche der Vorderseite der Halbleiterscheibe zu glätten. Zum Abscheiden der epitaktischen Schicht wird die Substratscheibe auf Abscheidetemperatur gebracht und die Vorderseite der Substratscheibe mit einem Abscheidegas in Kontakt gebracht, während die Rückseite der Substratscheibe vorzugsweise weiterhin dem Einfluss des Spülgases ausgesetzt bleibt. Das Abscheidegas enthält Verbindungen, die nach ihrer chemischen Spaltung die schichtbildenden Stoffe bereitstellen. Zu diesen Stoffen gehören vorzugsweise Silicium, Germanium und Dotierstoffe wie Bor. Besonders bevorzugt ist ein Abscheidegas enthaltend Trichlorsilan, Wasserstoff und Diboran. Nach dem Abscheiden der epitaktischen Schicht wird die beschichtete Halbleiterscheibe abgekühlt, beispielsweise in einem Strom aus Wasserstoff, der durch den Reaktor geleitet wird.

Gegenstand der Erfindung ist schließlich auch ein Suszeptor zum Ablegen einer Halbleiterscheibe beim Abscheiden einer Schicht auf einer Vorderseite der Halbleiterscheibe durch chemische Gasphasenabscheidung (CVD), gekennzeichnet durch eine gasdurchlässige Struktur mit einer Porosität von mindestens 15 %, einer Dichte von 0,5 bis 1,5 g/cm³, einem Porendurchmesser kleiner als 0,1 mm und einer inneren Oberfläche der Poren größer als 10000 cm² / cm³. Der Suszeptor besteht vorzugsweise aus Graphit oder aus Graphitfasern mit den genannten Eigenschaften, besonders bevorzugt aus mit Siliciumcarbid beschichtetem Graphit oder mit Siliciumcarbid beschichteten Graphitfasern mit den genannten Eigenschaften.

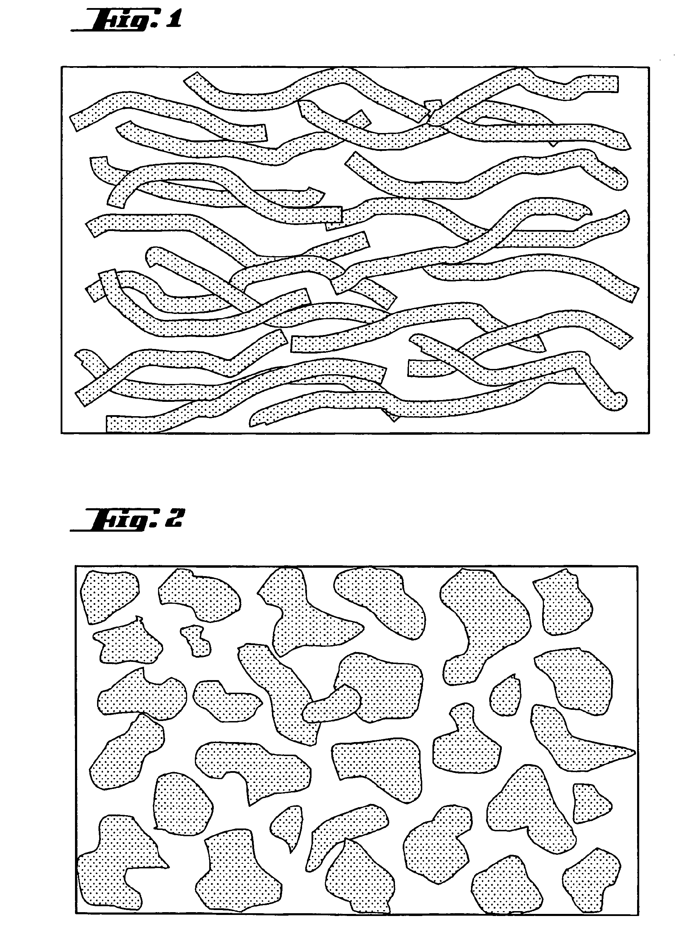

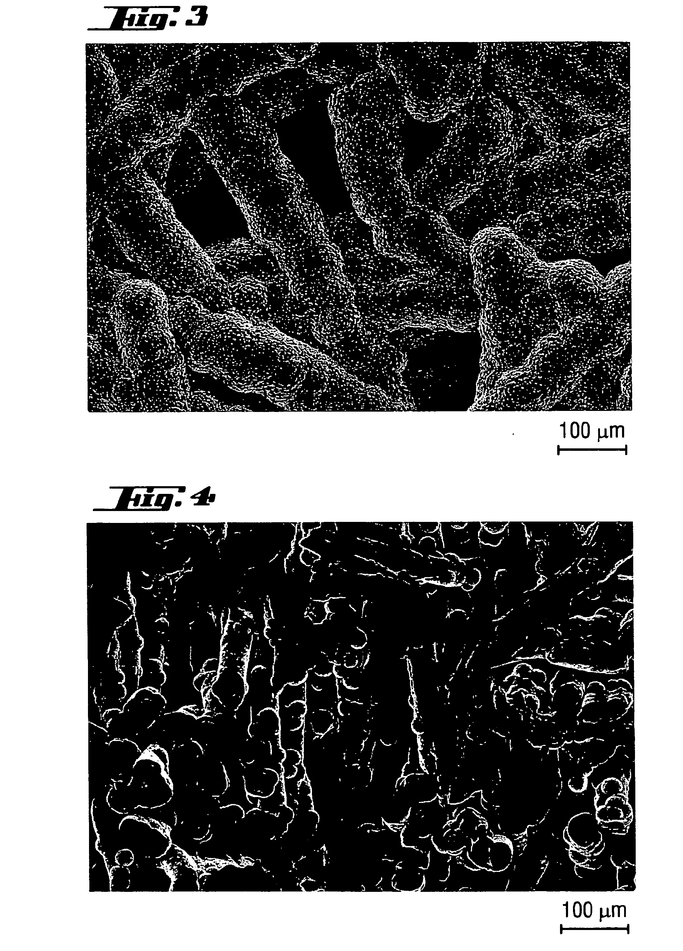

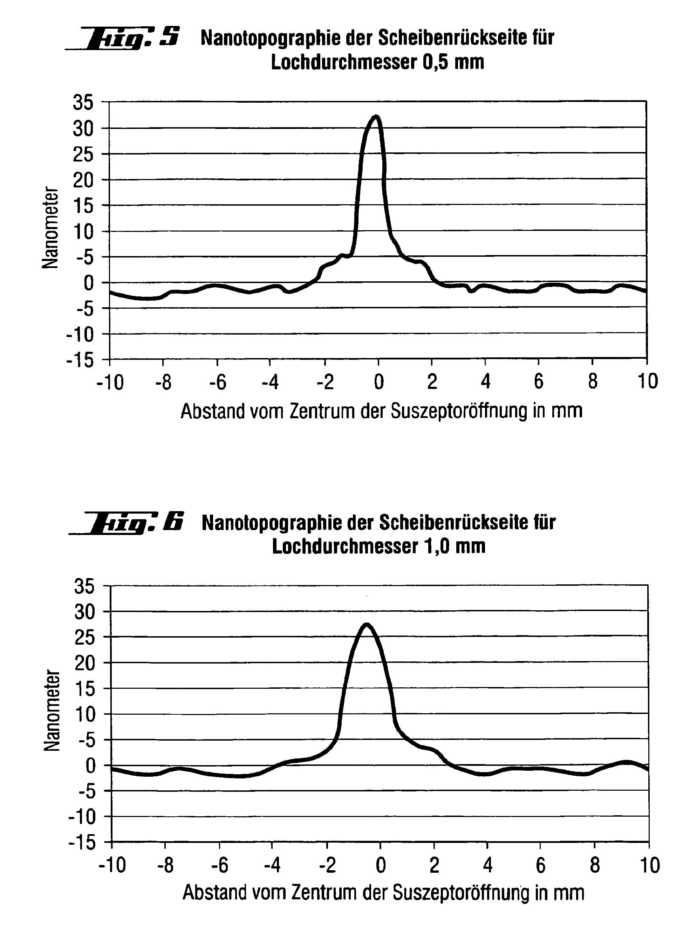

Fig.1 zeigt schematisch in Schnittdarstellung einen erfindungsgemäßen Suszeptor mit Faserstruktur. Fig. 2 zeigt in gleicher Darstellung einen erfindungsgemäßen Suszeptor mit Partikelstruktur. Fig. 3 zeigt in Aufsicht (Blickrichtung senkrecht auf Oberfläche) exemplarisch einen erfindungsgemäßen Suszeptor bestehend aus Graphitfasern. Deutlich zu erkennen sind die Poren in der Oberfläche. Fig. 4 zeigt einen Querschnitt desselben Suszeptors aus Fig. 3. Zu erkennen sind wieder die einzelnen Graphitfasern und Poren im Suszeptor.

Die Graphitfasern können in einer geordneten Struktur (isotrop) oder in einer ungeordneten Struktur (anisotrop) vorliegen. Bei einer Beschichtung der Fasern mit Siliciumcarbid ist es bevorzugt, dass die Dicke der Siliciumcarbid-Schicht an der Oberfläche des Suszeptors größer ist, als im Inneren des Suszeptors. Die notwendige Porosität und Dichte des Suszeptormaterials lassen sich durch geeignetes Verdichten von Fasern oder Partikeln während der Herstellung des Suszeptors einstellen. Der Suszeptor hat vorzugsweise eine tellerähnliche Form mit einer Vertiefung zur Aufnahme der Halbleiterscheibe, so dass die Rückseite der Halbleiterscheibe nach dem Ablegen der Halbleiterscheibe auf den Suszeptor dem Boden des Suszeptors zugewandt ist. Der Boden ist vorzugsweise geschlossen und nur aufgrund der Porosität des Suszeptormaterials gasdurchlässig. Allerdings können am äußeren Rand der Vertiefung schlitzartige Durchgänge vorhanden sein, ebenso wie Durchgänge im Boden des Suszeptors für Stifte zum Anheben und Absenken der Halbleiterscheibe. Die Durchgänge für die Stifte sind jedoch während des Einsatzes des Suzeptors durch die Präsenz der Stifte verschlossen. Der Suszeptor wird vorzugsweise in einem Einzelscheibenreaktor eingesetzt und ist vorzugsweise zur Aufnahme von Halbleiterscheiben mit einem Durchmesser von 150 mm, 200 mm, 300 mm ausgelegt. Besonders bevorzugt ist die Verwendung des Suszeptors in Verbindung mit Einzelscheibenreaktoren von ASM und Applied Materials.

Die Erfindung wird nachfolgend an einem Beispiel mit dem Stand der Technik verglichen. Für den Vergleich wurde ein üblicher Suszeptor aus mit Siliciumcarbid beschichtetem Graphit mit Löchern verschiedener Durchmesser versehen (Vergleichsbeispiel). Die Dichte des Materials betrug etwa 1,85 g/cm³. Ein gleichartig geformter Suszeptor wurde aus mit Siliciumcarbid beschichtetem Graphitfilz gefertigt (Beispiel). Das Material dieses Suszeptors hatte eine Porosität von etwa 25 % und eine Dichte von etwa 1,35 g/cm³ und einem mittleren Porendurchmesser von 80µm und einer inneren Oberfläche der Poren von ca. 10000 cm² / cm³.

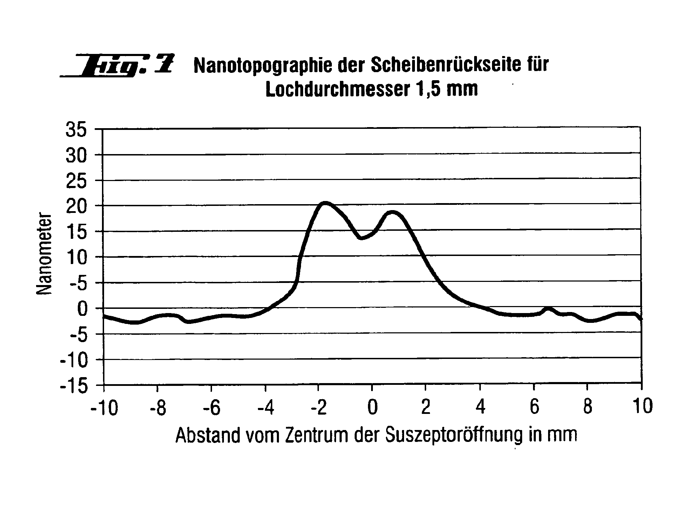

Mehrere Substratscheiben aus Silicium mit p-Dotierung und Bor als Dotierstoff wurden in einem Einzelscheibenreaktor mit einer p⁺-dotierten (ebenfalls mit Bor als Dotierstoff) Epitaxieschicht aus Silicium versehen, wobei jeweils einer der oben genannten Suszeptorentypen zum Einsatz kam. Das Abscheiden der Epitaxieschicht erfolgte gemäß dem Stand der Technik und umfasste einen herkömmlichen "prebake"-Schritt. Die produzierten Halbleiterscheiben wurden auf "autodoping", "halo" und Nanotopographie der Vorderseite und der Rückseite untersucht. Signifikante Unterschiede ergaben sich nur bei der Betrachtung der Nanotopographie der Rückseite. Hier zeigten Halbleiterscheiben, die unter Verwendung eines Suszeptors gemäß des Vergleichsbeispiels beschichtet worden waren, deutlich schlechtere Nanotopographie-Werte, als erfindungsgemäß hergestellte Halbleiterscheiben. Keine der Halbleiterscheiben des Vergleichsbeispiels erreichte Nanotopographie-Werte von unter 5 nm bezogen auf ein Messfenster mit einer Fläche von 10 * 10 mm. Wie die Figuren 5 bis 7 zeigen, war die feststellbare Höhenabweichung umso größer, je kleiner der Durchmesser der Löcher im Suszeptor gewesen war. Hingegen wiesen sämtliche Halbleiterscheiben des Beispiels auf der Rückseite Nanotopographie-Werte von unter 5 nm sowie einen Haze von weniger als 5ppm auf.

## Patentansprüche

1. Suszeptor zum Ablegen einer Halbleiterscheibe beim Abscheiden einer Schicht auf einer Vorderseite der Halbleiterscheibe durch chemische Gasphasenabscheidung (CVD), **gekennzeichnet durch** eine gasdurchlässige Struktur mit einer Porosität von mindestens 15 %, einer Dichte von 0,5 bis 1,5 g/cm³, einem Porendurchmesser kleiner als 0,1 mm und einer inneren Oberfläche der Poren größer als 10000 cm² / cm³ .

2. Suszeptor nach Anspruch 1, **dadurch gekennzeichnet, dass** die Struktur im Wesentlichen Fasern aus Graphit enthält.

3. Suszeptor nach Anspruch 1, **dadurch gekennzeichnet, dass** die Struktur im Wesentlichen Graphitpartikel enthält.

4. Suszeptor nach einem der Ansprüche 1 bis 3, **gekennzeichnet durch** eine Beschichtung aus Siliciumcarbid.

5. Suszeptor nach Anspruch 4, **gekennzeichnet durch** eine Dicke der Beschichtung aus Siliciumcarbid, die von einer Oberfläche des Suszeptors zu einem Inneren des Suszeptors hin abnimmt.

6. Halbleiterscheibe mit einer Rückseite und einer durch chemische Gasphasenabscheidung (CVD) beschichteten Vorderseite und einer polierten oder geätzten Rückseite, **dadurch gekennzeichnet, dass** die Nanotopographie der Rückseite, ausgedrückt als Höhenschwankung PV (= peak to valley), kleiner als 5 nm ist ist und gleichzeitig der "halo" der Rückseite, ausgedrückt als Haze, kleiner als 5 ppm ist.

7. Verfahren zur Herstellung einer Halbleiterscheibe mit einer, auf einer Vorderseite durch chemische Gasphasenabscheidung (CVD) abgeschiedenen Schicht und einer polierten oder geätzten Rückseite, wobei die Halbleiterscheibe zum Abscheiden der Schicht auf einem Suszeptor gemäß Anspruch 1 abgelegt wird, so dass die Rückseite der Halbleiterscheibe einem Boden des Suszeptors zugewandt ist, **dadurch gekennzeichnet, dass** gasförmige Stoffe aus einem Bereich über der Rückseite der Halbleiterscheibe durch diffusiven Gastransport durch den Suszeptor hindurch in einen Bereich über der Rückseite des Suszeptors gelangen.

## Claims

1. Susceptor for a semiconductor wafer to be placed on during the deposition of a layer on a front surface of the semiconductor wafer by chemical vapor deposition (CVD), **characterized by** a gas-permeable structure with a porosity of at least 15%, a density of from 0.5 to 1.5 g/cm³, a pore diameter of less than 0.1 mm and an internal surface area of the pores which is greater than 10 000 cm² / cm³.

2. Susceptor according to Claim 1, **characterized in that** the structure substantially comprises graphite fibers.

3. Susceptor according to Claim 1, **characterized in that** the structure substantially comprises graphite particles.

4. Susceptor according to one of Claims 1 to 3, **characterized by** a coating of silicon carbide.

5. Susceptor according to Claim 4, **characterized by** a silicon carbide coating thickness which decreases from a surface of the susceptor toward the interior of the susceptor.

6. Semiconductor wafer having a back surface and a front surface which has been coated by chemical vapor deposition (CVD) and a polished or etched back surface, **characterized in that** the nanotopography of the back surface, expressed as the PV (= peak to valley) height fluctuation, is less than 5 nm, and at the same time the halo of the back surface, expressed as haze, is less than 5 ppm.

7. Process for producing a semiconductor wafer having a layer deposited on a front surface by chemical vapor deposition (CVD) and a polished or etched back surface, the semiconductor wafer, for deposition of the layer, being placed on a susceptor according to Claim 1, so that the back surface of the semiconductor wafer faces a base of the susceptor, **characterized in that** gaseous substances pass through the susceptor through diffusive gas transport from a region above the back surface of the semiconductor wafer into a region above the back surface of the susceptor.

## Revendications

1. Suscepteur destiné à déposer une tranche semi-conductrice lors du dépôt d'une couche sur la face avant de la tranche semi-conductrice par dépôt chimique en phase gazeuse (CVD), **caractérisé par** une structure perméable au gaz avec une porosité d'au moins 15%, une densité de 0,5 à 1,5 g/cm³, un diamètre de pores inférieur à 0,1 mm et une surface interne des pores supérieure à 10 000 cm²/cm³.

2. Suscepteur selon la revendication 1, **caractérisé en ce que** la structure contient essentiellement des fibres de graphite.

3. Suscepteur selon la revendication 1, **caractérisé en ce que** la structure contient essentiellement des particules de graphite.

4. Suscepteur selon l'une quelconque des revendications 1 à 3, **caractérisé par** un revêtement en carbure de silicium.

5. Suscepteur selon la revendication 4, **caractérisé par** une épaisseur du revêtement en carbure de silicium qui diminue d'une surface du suscepteur vers l'intérieur du suscepteur.

6. Tranche semi-conductrice avec une face arrière et une face avant revêtue par un dépôt chimique en phase gazeuse (CVD) et une face arrière polie ou décapée, **caractérisée en ce que** la nanotopographie de la face arrière, exprimée comme variation de la hauteur PV (= peak to valley), est inférieure à 5 nm et, simultanément, le "halo" de la face arrière, exprimé comme voile, est inférieur à 5 ppm.

7. Procédé pour la production d'une tranche semi-conductrice avec une couche déposée sur la face avant par dépôt chimique en phase gazeuse (CVD) et une face arrière polie ou décapée, la tranche semi-conductrice étant déposée, pour le dépôt de la couche, sur un suscepteur selon la revendication 1, de telle manière que la face arrière de la tranche semi-conductrice est orientée vers le fond du suscepteur, **caractérisé en ce que** des substances gazeuses arrivent, d'une zone, via la face arrière de la tranche semi-conductrice, par un transport gazeux par diffusion au travers du suscepteur, dans une zone au-dessus de la face arrière du suscepteur.
